# EUROPÄISCHE PATENTSCHRIFT

(11) **EP 1 500 140 B1**
(45) Veröffentlichungstag und Bekanntmachung des Hinweises auf die Patenterteilung: **30.06.2010**
(21) Anmeldenummer: 03722222.1
(22) Anmeldetag: 17.03.2003
(51) Int. Cl.: H01L 23/522

(54) **INTEGRIERTE SCHALTUNGSANORDNUNG MIT INTEGRIERTEM KONDENSATOR**
INTEGRATED CIRCUIT WITH INTEGRATED CAPACITOR
CIRCUIT INTEGRE A CONDENSATEUR INTEGRE

(30) Priorität: 29.04.2002 DE 10219116
(43) Veröffentlichungstag der Anmeldung: 26.01.2005
(73) Patentinhaber: Infineon Technologies AG, 85579 Neubiberg (DE)
(72) Erfinder: BARTH, Hans-Joachim, 81245 München (DE); HOLZ, Jürgen, 80804 München (DE)
(74) Vertreter: Karl, Frank
(86) Internationale Anmeldenummer: PCT/DE2003/000862
(87) Internationale Veröffentlichungsnummer: WO 2003/094233

(56) Entgegenhaltungen:
- EP-A- 1 182 703
- US-A- 5 185 650
- US-A- 6 064 108
- US-A1- 2001 013 660

## Beschreibung

Die Erfindung betrifft eine integrierte Schaltungsanordnung, die eine Vielzahl von integrierten Bauelementen in einem Halbleitersubstrat enthält. Außerdem enthält die integrierte Schaltungsanordnung zwei zueinander benachbarte oberste Verbindungslagen, die jeweils eine Vielzahl elektrisch leitender Verbindungsabschnitte enthalten, welche Teile von elektrisch leitenden Verbindungen zu den Bauelementen bilden. Zwischen den beiden Verbindungslagen ist eine Zwischenlage angeordnet.

Die integrierten Bauelemente sind beispielsweise MOS-Transistoren (Metall Oxide Semiconductor) oder Bipolartransistoren, d.h. typische Halbleiterbauelemente. Die Halbleiterbauelemente sind in einem Substrat angeordnet, das beispielsweise aus Silizium besteht.

Die Verbindungslagen werden auch als Metallisierungslagen bezeichnet, weil sie üblicherweise aus einem Metall hergestellt werden, beispielsweise aus Aluminium oder aus Kupfer. In diesem Zusammenhang wird auch von Metallisierungsebenen gesprochen, z.B. Metall 1 und Metall 2. Jede Verbindungslage wird in einem extra Abscheideprozess hergestellt und liegt in einer Ebene parallel zu den anderen Verbindungslagen.

Die Zwischenlage wird üblicherweise durch eine Barriereschicht, z.B. aus Siliziumnitrid, mit einer im Vergleich zur gesamten Zwischenlage geringen Dicke und aus einer vergleichsweise dicken Schicht mit kleiner Dielektrizitätskonstante k gebildet. Die Zwischenlage zwischen den Verbindungslagen wird üblicherweise vergleichsweise dick ausgebildet, beispielsweise 500 nm. Durch diese Maßnahmen soll erreicht werden, dass die kapazitive Kopplung zwischen den Verbindungslagen möglichst klein ist.

Es ist Aufgabe der Erfindung, eine einfach aufgebaute integrierte Schaltungsanordnung anzugeben, die insbesondere verbesserte elektronische Eigenschaften im Vergleich zu den bekannten Schaltungsanordnungen hat. Außerdem sollen zugehörige Herstellungsverfahren angegeben werden.

Die auf die Schaltungsanordnung bezogene Aufgabe wird durch eine Schaltungsanordnung mit den im Patentanspruch 1 angegebenen Merkmalen erfüllt. Bei der erfindungsgemäßen Schaltungsanordnung enthält die Zwischenlage ein Material mit einer Dielektrizitätskonstante größer 4, so dass sich, wobei der Abstand zwischen den beiden Verbindugnslagen kleiner als 200 nm ist, eine flächenbezogene Kapazität größer als 0,5 fF/µm² (Femtofarad je Quadratmikrometer) ergibt. Vorzugsweise ist die flächenbezogene Kapazität größer als 0,7 fF/µm² und erreicht bei einer Ausgestaltung einen Wert von etwa 2,0 fF/µm². Dies bietet zahlreiche Vorteile. So können innerhalb der ohne zusätzlichen Masken auf einfache Art Kondensatoren mit linearer Übertragungsfunktion angeordnet werden. Zwischen Verbindungsleitungen zum Führen der Betriebsspannung können auf einfache Art und Weise sogenannte Block- bzw. Stütz-Kondensatoren zum Unterdrücken kurzer Spannungsspitzen hergestellt werden. US-A-2001/0013660 zeigt einen Kondensator aus oberen Verbindungslagen einer integrierten Schaltung. Weiterhin vereinfacht sich aufgrund der Zwischenlage mit verringerter Dicke die Herstellung von Kontakten zwischen den Verbindungslagen. Erfindungsgemäß durchdringt ein Kontaktloch nur die Zwischenlage und verbindet eine Anschlußplatte mit einem unter ihr liegenden Verbindungslagenabschnitt.

Die erfindungsgemäße Schaltungsanordnung enthält, eine Passivierungsschicht zum Schutz vor Umwelteinflüssen. Die PassivierungsSchicht enthält mindestens eine Aussparung, die zu der Anschlussplatte der obersten Verbindungslage fuhrt. Diese Anschlussplatte bildet einen Anschluss zum Anschließen einer äußeren elektrisch leitenden Verbindung. Ist die äußere elektrisch leitende Verbindung ein Bonddraht, so wird der Anschluss auch als Bond-Pad bezeichnet. Jedoch kann der Anschluss auch für die sogenannte Plättchen-Schnellmontage-Technik (Flip-Chip-Technik) genutzt werden. Bestehen die Verbindungsabschnitte aus Aluminium oder einer Aluminiumlegierung, so lassen sich bisher erprobte Technologien zum Anschließen äußerer Verbindungen nutzen, ohne beispielsweise neue Bondtechniken entwickeln zu müssen.

Bei einer nächsten Weiterbildung der erfindungsgemäßen Schaltungsanordnung enthält die Passivierungsschicht mindestens eine Aussparung, die zu einem Verbindungsabschnitt führt. Dieser Verbindungsabschnitt verbindet zwei Bauelemente und kann bzw. konnte mit Hilfe eines Laserstrahls unterbrochen werden, um so eine von mindestens zwei Schaltungsvarianten auszuwählen. Solche Verbindungsabschnitte werden auch als Durchbrennverbindungen oder Schmelzverbindungen bzw. als Fuses bezeichnet.

Die Aussparungen für die Anschlussflächen und für die Schmelzverbindungen lassen sich gleichzeitig herstellen. Da die Zwischenlage bei der erfindungsgemäßen Schaltungsanordnung im Vergleich zu herkömmlichen Zwischenlagen sehr dünn ausgeführt werden kann, lässt sich das Strukturieren und Füllen von Kontaktöffnungen im Bereich der Anschlüsse oder im Bereich der Schmelzverbindung mit Aluminium oder einem anderen Material vereinfachen. Das sogenannte Aspektverhältnis ist günstiger als bei den bisher üblichen dickeren Zwischenlagen. So liegt das Aspektverhältnis bspw. bei 0,2 wenn die Zwischenlage etwa 100 nm dick ist und das Kontaktloch einen Durchmesser von 0,5 Mikrometern hat. Auch sind beispielsweise bei Aluminiumverbindungslagen keine relativ hochohmigen Wolfram-Füllungen für die Kontaktlöcher erforderlich.

Erfindungsgemäß dient mindestens ein Verbindungsabschnitt in der einen Verbindungslage und mindestens ein Verbindungsabschnitt in der anderen Verbindungslage zum Führen einer festen Betriebsspannung. Die Verbindungsabschnitte zum Führen der Betriebsspannungen überlappen sich in einem Bereich, dessen Flächenkapazität einen Kondensator bildet, der kurze Störimpulse wirksam unterdrückt. Ein solcher Kondensator wird auch als Blockkondensator bzw. Stütz-Kondensator bezeichnet. Die Verbindungsabschnitte zum Führen der Betriebsspannungen befinden sich bei einer Ausgestaltung in einem digitalen Schaltungsteil der Schaltungsanordnung. Gerade im digitalen Schaltungsteil werden durch Schaltvorgänge die kurzen Störimpulse erzeugt. Um Schäden an den Bauelementen und Schaltkreisen zu verhindern, sind die Blockkondensatoren erforderlich. Die Betriebsspannungsleitungen sind im Bereich der Blockkondensatoren auf einer erheblich größeren Fläche ausgeführt, als es zur Leitung des jeweiligen Stroms eigentlich erforderlich wäre. So ist diese Fläche beispielsweise fünf, zehn oder sogar hundert mal größer als zur Stromleitung erforderlich. Aufgrund dieser großen Flächen lassen sich Kapazitäten beispielsweise im Bereich von einem Nanofarad bis zu zehn Nanofarad erzeugen.

Der zusätzliche Flächenbedarf für die Blockkondensatoren bleibt dennoch verhältnismäßig klein, weil die Blockkondensatoren gleichzeitig zum Zuführen der Betriebsspannung dienen. Außerdem müssen die Blockkondensatoren nicht auf andere Weise erzeugt werden, beispielsweise durch MOS-Kondensatoren, die eine zusätzliche aktive Gateoxidfläche erfordern. Mit anderen Worten wird die aktive Gateoxidfläche insgesamt nicht vergrößert, wie es der Fall wäre, wenn die Blockkondensatoren als MOS-Kondensatoren hergestellt werden. Für Schaltungen mit signifikantem Anteil an Block-Kapazitäten führt dies zu einem Ausbeute- und Zuverlässigkeitsvorteil.

Durch die Verteilung der Blockkondensatoren entlang der Betriebsspannungsleitungen ist es bei einem geeigneten Layout möglich, eine Erzeugung von LC-Schwingkreisen mit hoher Güte zu vermeiden. Die Betriebsspannungsleitungen bedecken die jeweilige Ebene möglichst ganzflächig, d.h. zu einem Anteil größer 90 Prozent oder sogar größer 95 Prozent. Um parasitäre Schwingkreise zu vermeiden werden die Betriebsspannungsleitungen beispielsweise als Netz ausgestaltet, um eine Vielzahl voneinander verschiedener parasitärer Schwingkreise zu erzeugen und eine Bedämpfung der Schwingkreise zu erreichen. Die Dämpfung lässt sich gezielt durch Leiterbahnabschnitte mit kleiner Breite oder durch Schlitze quer zur Stromflussrichtung erhöhen.

Bei einer nächsten Ausgestaltung der integrierten Schaltungsanordnung enthalten die beiden obersten Verbindungslagen die Elektroden mindestens eines weiteren Kondensators, wobei ein Teil der Zwischenlage das Dielektrikum des Kondensators bildet. Auf diese Weise entsteht ein sogenannter MIM-Kondensator (Metal Isolator Metal). Bei diesen Kondensatoren handelt es sich um Kondensatoren mit einer linearen Übertragungsfunktion, wie sie bei analogen Schaltungen häufig benötigt werden, beispielsweise bei Schaltungen mit geschalteten Kondensatoren.

In einem sogenannten Mischsignalteil (Mixed Signal), d.h. in dem mit analogen Signalen arbeitenden Teil, der Schaltungen, wo in der Regel im Vergleich zum digitalen Schaltungsteil weniger Metalllagen zur Verdrahtung benötigt werden, können daher die obersten beiden Metalllagen zur Herstellung hochlinearer Kondensatoren (LIN-Caps) verwendet werden. Es lassen sich flächenbezogen Kapazitäten größer als 0,5 fF/µm² herstellen. Im Fall von Materialien mit einem hohen Dielektrizitätswert, d.h. wesentlich größer als vier, lassen sich sogar Flächendichten bis etwa 2,0 fF/µm² erreichen. Die Schichtdicke des Dielektrikums in der Zwischenlage ist dabei im Wesentlichen nur durch die Ätzselektivität begrenzt. Beispielsweise bei einer oberen Aluminium-Verbindungslage durch die Aluminium/Barrieren-Ätzrate im Vergleich zur Dielektrikumsätzrate. Bei dünneren Aluminium/Barrieren-Stapeln oder hochselektiven Aluminium/Ätzprozessen kann die Schichtdicke des Dielektrikums auch noch unter die typischen 100 nm reduziert werden. Durch eine Abschirmung unter den Kondensatoren ist es möglich, die darunterliegende Fläche für Schaltungsfunktionen mit Analogsignalen zu nutzen.

Damit lassen sich die linearen Kondensatoren für die Analogsignale ohne zusätzliche Lithografieschritte gleichzeitig mit der Herstellung der Verbindungslagen erzeugen. Der Flächenbedarf für die linearen Kondensatoren ist dabei minimal, da unter den Kondensatoren die Realisierung von Analog-Schaltungen möglich ist. Die obersten obiden Metalllagen müssen im analog arbeitenden Schaltungsteil nicht unbedingt zur Verdrahtung genutzt werden, da der Flächenbedarf für den analogen Schaltungsteil in der Regel nicht durch die Verdrahtung bestimmt ist. Die Summe der Kapazitätswerte der linearen Kondensatoren liegt beispielsweise zwischen einem und zehn Nanofarad.

Liegen die Betriebsspannungsleitungen und/oder die Anschlüsse für die äußeren Verbindungen sowie die linearen Kondensatoren in den gleichen Verbindungslagen, so ergibt sich eine besondere Ausgestaltung. Dieser Ausgestaltung liegt die Erkenntnis zugrunde, dass die Strukturen in den Lithografie-Ebenen für die Betriebsspannungsführung bzw. die äußeren Anschlüsse und für die Herstellung der bisher für die linearen Kapazitäten verwendeten Ebenen an verschiedenen Stellen in lateraler Richtung liegen. Deshalb ist es möglich, diese Ebenen in einer bzw, zwei Ebenen anzuordnen. Wie oben bereits erwähnt, wird die Isolationsschicht dünner als sonst üblich hergestellt. Durch die Einbettung der Blockkondensatoren in die Metallebenen für die Betriebsspannungszuführung ergibt sich außerdem ein weiterer Vorteil. Der bisher unerwünschte parasitäre Effekt der kapazitiven Kopplung von zwei übereinanderliegenden und benachbarten Metallebenen wird nun ausgenutzt, um eine Struktur mit linearen Kondensatoren, zu erzeugen. Für die Herstellung der linearen Kondensatoren waren bisher mehrere zusätzliche Lithografiemasken erforderlich. Die kapazitive Kopplung zwischen den Verbindungsabschnitten der Metallebenen ist bei der Schaltungsanordnung kein Nachteil, sofern die Metallbahnen für die Zuführung der Betriebsspannung benutzt werden. Die kapazitive Kopplung ist sogar ein Vorteil, weil sie für die Erzeugung der Kapazität der Blockkondensatoren dient, die nun nicht mehr separat herzustellen sind.

Werden mehrere der oben angegebenen Ausgestaltungen kombiniert, so entsteht ein universell einsetzbares FBEOL-Konzept (Far Back End Of Line) mit einem breiten Anwendungsspektrum:
- hochlineare LIN-Kapazitäten (größer 0,5 bzw. 0,7 fF/µm²),
- stark gekoppelte Block-Kapazitäten,
- stark gekoppelte Betriebsspannungszuführungen,
- Anschlussplatten für äußere Verbindungen (Wirebond-Pads) oder alternativ flip-chip-Anschlussplatten (Pads),
- Laser-Schmelzverbindungen (Fuses), und
- Signal-Leitungen in der letzten Cu-Ebene und/oder A1-Ebene.

Dabei sind zusätzliche Prozessschritte zu den bisher üblichen Prozessschritten nicht erforderlich, so dass auch keine zusätzlichen Prozesskosten entstehen. Die Anzahl der Prozessschritte lässt sich bei der Herstellung von MIM-Kondensatoren bzw. Blockkondensatoren sogar verringern, durch die Ausnutzung des bisher unerwünschten parasitären Effektes.

So ist beispielsweise die bisher übliche Oxid-Schicht über der SiN-Barrierenschicht nicht mehr erforderlich. Statt dessen wird beispielsweise die SiN-Schicht dicker als bisher aufgebracht oder alternativ durch einen Schichtstapel ersetzt, der unten näher erläutert wird. Die Schichtdicke der Zwischenlage wird nach unten im Wesentlichen durch die Sicherstellung der Durchschlagfestigkeit und durch die Verhinderung von Elektromigration bestimmt. Nach oben hin wird die Schichtdicke insbesondere durch die Größe der geforderten Kapazität größer 0,5 fF/µm² begrenzt.

Bei einer nächsten Weiterbildung hat das Material der Zwischenlage eine relative Dielektrizitätskonstante größer vier oder größer sechs. So liegt die Dielelektrizitätskonstante von Siliziumnitrid zwischen sieben und acht. Materialien mit Dielektrizitätskonstanten zwischen 4 und 30 lassen sich auf einfache Art in einem Prozess zur Herstellung eines integrierten Schaltkreises einbeziehen.

Erfindungsgemäß haben die beiden Verbindungslagen einen Abstand kleiner als 200 nm, insbesondere kleiner als 100 nm voneinander. Der Abstand der Verbindungslagen sollte jedoch größer als 50 nm sein, um kleine Ausfallsraten zu gewährleisten.

Erfindungsgemäß enthält die näher an den Bauelementen liegende Verbindungslage als Hauptbestandteil Kupfer. Hauptbestandteil ist ein Bestandteil, dessen Anteil an der Gesamtzahl der Atome in dem Stoff mindestens 80 Prozent beträgt. Kupfer zeichnet sich im Vergleich zu Aluminium insbesondere durch seine höhere Leitfähigkeit aus. Bei einer Ausgestaltung ist die oberste Verbindungslage eine Schicht, die Aluminium als Hauptbestandteil enthält. Damit lassen sich bekannte Herstellungstechnologien einsetzen, insbesondere zum Herstellen von äußeren Verbindungen. Außerdem können Kontaktlöcher zwischen den Verbindungslagen auf Grund der geringen Dicke der Zwischenlage mit Aluminium gefüllt werden. Das Füllen der Kontaktlöcher und das Abscheiden des Aluminiums für die oberste Verbindungslage kann in einem Verfahrensschritt ausgeführt werden, d.h. ohne Änderung der Prozessbedingungen. Bei einer alternativen Ausgestaltung ist die oberste Verbindungslage eine Schicht, die als Hauptbestandteil Kupfer enthält. Auch für solche Schichten gibt es Verbindungstechniken, die bereits Fertigungsreife erreicht haben oder diese in absehbarer Zeit erreichen werden. Sind beide Verbindungslagen aus Kupfer, so hat sie beispielsweise eine hohe Leitfähigkeit der Verbindungen zur Folge.

Bei einer anderen Weiterbildung enthält die Isolationsschicht mindestens einen der Bestandteile Nitrid, vorzugsweise Siliziumnitrid oder Aluminiumnitrid, Tantalpentoxid, Hafniumoxid oder Aluminiumoxid. Die genannten Materialien haben eine hohe Dielektrizitätskonstante, d.h. größer als vier, und lassen sich in einem Prozess zur Herstellung einer integrierten Schaltung verhältnismäßig einfach einsetzen.

Es ist möglich, die Isolationsschicht mit mindestens zwei Schichten bei verschiedenen Prozessbedingungen zu erzeugen, vorzugsweise unter Verwendung eines HDP-Verfahrens (High Density Plasma) und eines PECVD-Verfahrens (Plasma Enhanced Chemical Vapor Deposition). Durch diese Maßnahme lässt sich zunächst eine Teilschicht herstellen, die auf Grund ihrer Dichte möglichst gute Eigenschaften zum Verhindern von Elektromigration hat. Anschließend lässt sich eine Teilschicht herstellen, die eine besonders hohe Dielektrizitätskonstante hat.

Beispielsweie besteht die Isolationsschicht im Wesentlichen aus einer Siliziumnitridschicht, vorzugsweise kleiner 20 nm, die mit einem HDP-Verfahren abgeschieden worden ist, und aus einer dielektrischen Schicht, die mit einem PECVD-Verfahren abgeschieden worden ist, vorzugsweise mit einer Dicke größer 30 nm und vorzugsweise von etwa 80 nm.

Die dielektrische Schicht enthält eines der oben genannten Materialien mit großer Dielektrizitätskonstante. Vorzugsweise ist die dielektrische Schicht ein Mehrfachschichtstapel, die durch eine Unterbrechung der Abscheidung und anschließende Weiterführung der Abscheidung mit den gleichen Prozessbedingungen erzeugt worden ist. Die einzelnen Schichten des Mehrfachschichtstapels enthalten das gleiche Material.

Bei einer anderen Ausgestaltung ist die Isolationsschicht eine homogene Schicht, die hauptsächlich Siliziumnitrid enthält. Die Verarbeitung dieses Materials ist in der integrierten Schaltungstechnik problemlos möglich. Die Siliziumnitridschicht ist vorzugsweise größer als 50 nm und vorzugsweise etwa 100 nm dick, jedoch sollten 200 nm nicht überschritten werden.

Bei einer anderen Weiterbildung ist zwischen der zuerst hergestellten Verbindungslage und der Isolationsschicht eine Hilfslage angeordnet, die als Hauptbestandteil vorzugsweise eine Kupferverbindung aus Kupfer und mindestens einem der Elemente Kobalt, Wolfram, Phosphor oder Bor enthält. Die Hilfslage lässt sich jedoch auch aus einem Material mit vergleichbaren Eigenschaften bezüglich der Verhinderung von Elektromigration und/oder der Reaktion von Kupfer und Bestandteilen der Isolationsschicht herstellen. Die Hilfslage unterdrückt bei späteren Temperprozessen das Entstehen von Hillocks.

Auch durch geeignete Wahl der Abscheide- und Temperbedingungen der unteren Verbindungslage aus Kupfer lässt sich gewährleisten, dass Hillocks auf der unteren Verbindungslage vermieden bzw. vor dem Aufbringen der Isolationsschicht abgetragen werden können.

Insbesondere durch eine Kombination der genannte Maßnahmen lässt sich erreichen, dass Schaltungsanordnungen mit Ausfallsraten kleiner als 100 Fit, kleiner 10 Fit oder sogar kleiner als 1 Fit erzeugt werden können.

Bei einer nächsten Weiterbildung enthält die Schaltungsanordnung mehrere Verbindungslagen, beispielsweise sechs oder acht Verbindungslagen. Die Verbindungslagen mit der hohen flächenbezogenen Kapazität sind bei dieser Weiterbildung die am weitesten vom Substrat entfernten Verbindungslagen. Durch diese Maßnahme muss beispielsweise nur ein geringer Aufwand für eine Abschirmung betrieben werden.

Nachfolgend werden außerdem Verfahren beschrieben zum Herstellen einer Schaltungsanordnung insbesondere der erfindungsgemäßen Schaltungsanordnung oder einer ihrer Weiterbildungen. Bei einem Verfahren wird zunächst eine erste Verbindungslage erzeugt. Danach wird eine Zwischenlage abgeschieden. Anschließend wird eine weitere Verbindungslage abgeschieden. Die Zwischenlage wird so ausgebildet, dass die flächenbezogene Kapazität zwischen den beiden Verbindungslagen größer 0,5 fF/µm² ist.

Bei einer Weiterbildung des Verfahrens wird die Zwischenlage auf eine bereits abgeschiedene ebene Verbindungslage aufgebracht. Erst danach wird mit der Herstellung der oberen Verbindungslage begonnen.

Bei einer anderen Weiterbildung des Verfahrens wird zunächst die eine Verbindungslage aufgebracht. Danach werden die Aussparungen für Verbindungsabschnitte der oberen Verbindungslage aufgebracht. Erst dann wird die Zwischenlage aufgebracht. Bei dieser Weiterbildung enthält die obere Verbindungslage bspw. Kupfer.

Auch die Abscheidung der Zwischenlage bspw. auf Kupfer oder einer Kupferlegierung ist möglich.

Für die Verfahren und für deren Weiterbildungen gelten die oben genannten technischen Wirkungen ebenfalls.

Im Folgenden werden Ausführungsbeispiele der Erfindung an Hand der beiliegenden Zeichnungen erläutert. Darin zeigen:
- Figur 1: die Nutzung von Metalllagen in einer integrierten Schaltungsanordnung,
- Figur 2: eine erfindungsgemäße integrierte Schaltungsanordnung mit einer vorletzten Metalllage aus Kupfer und einer letzten Metalllage aus Aluminium,
- Figur 3: eine integrierte Schaltungsanordnung mit Metallla- gen aus Kupfer, wobei in der obersten Metalllage zuerst Kontaktlöcher (Vias) und dann Gräben für Verbindungsabschnitte hergestellt werden.

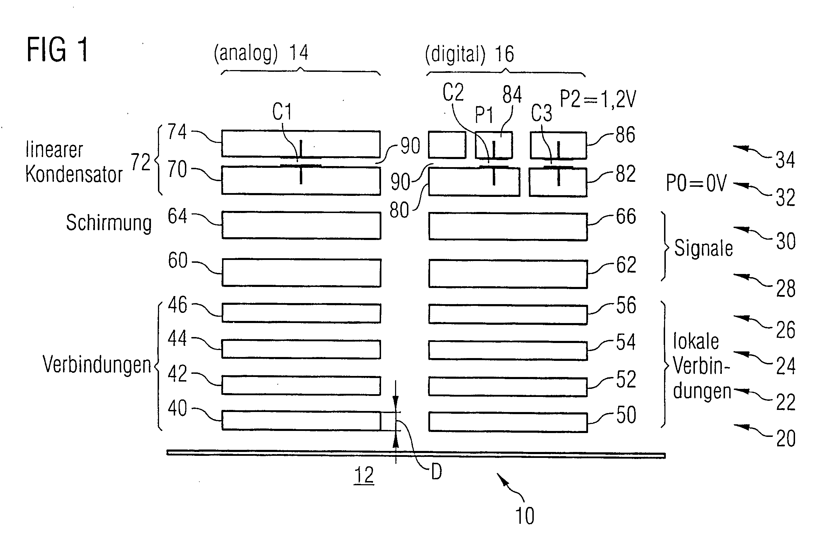

Figur 1 zeigt die Nutzung von Metalllagen einer integrierten Schaltungsanordnung 10. Die Schaltungsanordnung 10 enthält in einem Siliziumsubstrat 12 eine Vielzahl integrierter Halbleiter-Bauelemente, die jedoch in Figur 1 nicht dargestellt sind. Die im Substrat angeordneten Bauelemente bilden zwei räumlich getrennte Bereiche, nämlich einen Analogteil 14 und einen Digitalteil 16. Im Analogteil 14 werden hauptsächlich analoge Signale bearbeitet, d.h. Signale, die einen kontinuierlichen Wertebereich haben. Im Digitalteil 16 werden dagegen hauptsächlich digitale Signale bearbeitet, d.h. Signale, die beispielsweise nur zwei Werte haben, die zwei Schaltzuständen zugeordnet sind.

Die Schaltungsanordnung 10 enthält oberhalb des Siliziumsubstrates 12 außerdem acht Metalllagen 20 bis 34, zwischen denen keine weiteren Metalllagen sondern Isolierschichten angeordnet sind, die zwischen den Metalllagen 20 bis 32 bspw. eine Dicke von 500 nm haben. Die Metalllagen 20 bis 34 sind jeweils in einer Ebene angeordnet. Die Ebenen der Metalllagen 20 bis 34 sind parallel zueinander und auch parallel zur Hauptfläche des Siliziumsubstrats 12 angeordnet. Die Metalllagen 20 bis 34 erstrecken sich jeweils sowohl im Analogteil 14 als auch im Digitalteil 16.

Die untersten vier Metalllagen 20, 22, 24 und 26 enthalten im Analogteil 14 in der genannten Reihenfolge Verbindungsabschnitte 40, 42, 44 bzw. 46, welche Verbindungen zwischen den Bauelementen des Analogteils 14 bilden. Im Digitalteil 16 enthalten die Metalllagen 20, 22, 24 bzw. 26 in dieser Reihenfolge Verbindungsabschnitte 50, 52, 54 bzw. 56, die lokale Verbindungen zwischen den Bauelementen des Digitalteils 16 bilden. Die Verbindungsabschnitte 40 bis 56 haben senkrecht zum Substrat 12 eine Dicke D von beispielsweise 100 nm.

Die Metalllage 28 enthält im Analogteil 14 Verbindungsabschnitte 60, die Analogsignale führen und die Bauelemente des Analogteils 14 verbinden. Im Digitalteil 16 enthält die Metalllage 28 Verbindungsabschnitte 62, welche die Bauelemente des Digitalteils 16 verbinden und damit digitale Signale führen. Die Metalllage 30 enthält im Analogteil 14 einen Verbindungsabschnitt 64, der den Analogteil 14 ganzflächig bedeckt und zur Abschirmung des Analogteils vor darüber liegenden Bauelementen dient. Im Digitalteil 16 enthält die Metalllage 30 Verbindungsabschnitte 66, die digitale Signale führen, weil sie mit den Bauelementen des Digitalteils 16 verbunden sind. Die Verbindungsabschnitte 60 bis 66 haben die zweifache Dicke D.

Die Metalllagen 32 und 34 bilden die beiden obersten Metalllagen. Im Analogteil 14 enthält die Metalllage 32 eine Elektrode 70, einen Kondensator 72 mit linearer Übertragungsfunktion und einer Kapazität C1. Die andere Elektrode 74 des Kondensators 72 liegt in der Metalllage 34 oberhalb der Elektrode 70.

Im Digitalteil 16 enthält die Metalllage 32 zwei Verbindungsabschnitte 80 und 82, die ein Massepotential P0 von 0 Volt führen.

Oberhalb des Verbindungsabschnittes 80 liegt ein Verbindungsabschnitt 84, der ein Betriebspotential P1 von beispielsweise 2,5 Volt führt. Zwischen den Verbindungsabschnitten 80 und 84 wird eine Kapazität C2 gebildet, die zu einem Blockkondensator gehört.

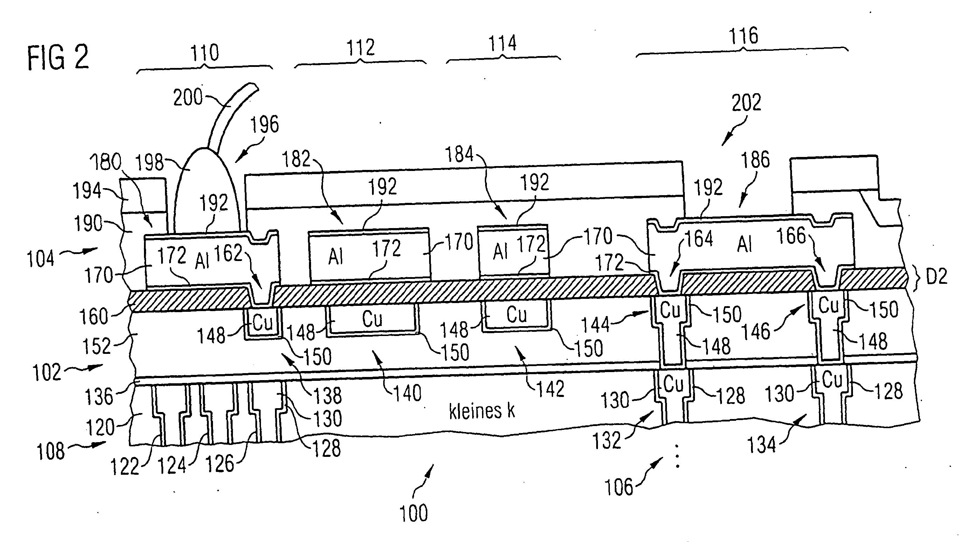

Oberhalb des Verbindungsabschnittes 82 befindet sich in der Metalllage 34 ein Verbindungsabschnitt 86, der ein zweites Betriebspotential P2 führt, beispielsweise 1,5 Volt. Zwischen dem Verbindungsabschnitt 82 und dem Verbindungsabschnitt 86 wird eine Kapazität C3 gebildet, die zu einem weiteren Blockkondensator gehört. Die Größe der Kapazitäten C1, C2 und C3 wird einerseits durch die Größe der sich überlappenden Verbindungsabschnitte 70 bis 86 bestimmt. Andererseits wird die flächenbezogene Kapazität zwischen den Verbindungsabschnitten 70 und 74 bzw. 80 und 84 bzw. 82 und 86 durch die Ausbildung einer Zwischenlage 90 bestimmt, welche zwischen den Metalllagen 32 und 34 liegt. Die Zwischenlage 90 ist so ausgebildet, dass sich eine flächenbezogene Kapazität größer 0,5 fF/µm² ergibt. Ausführungsbeispiele zum Ausbilden der Zwischenlage 90 werden unten an Hand der Figuren 2 bis 4 näher erläutert.

Die Verbindungsabschnitte 70 bis 86 haben die vierfache Dicke D und sind damit insbesondere zum Leiten hoher Ströme geeignet, wie sie in Verbindungsabschnitten 80 bis 86 zum Zuführen der Betriebsspannung auftreten.

Figur 2 zeigt eine Erfindungsgemäße Schaltungsanordnung 100 mit einer vorletzten Metalllage 102 und einer letzten Metalllage 104. Unter der vorletzten Metalllage 108 angeordnete Metalllagen 106 und ein Substrat der Schaltungsanordnung 100 sind durch Punkte angedeutet.

Als Beispiele für Bauelemente, die in den beiden obersten Metalllagen 102 und 104 angeordnet werden können, sind in Figur 2 eine Bondverbindung 110, ein linearer Kondensator 112, ein zwischen Betriebsspannungsleitungen angeordneter Blockkondensator 114 und eine sogenannte Schmelzverbindung 116 dargestellt.

Die Metalllage 108 enthält als Isoliermaterial ein Material mit einer kleinen Dielektrizitätskonstante k (Blok - Barrier low k), beispielsweise SILK (silicon low k), d.h. poröses Siliziumdioxid. Im Bereich der Bondverbindung 110 enthält die Metalllage 108 eine Vielzahl von Kontaktlöchern 122 bis 126 (sea of vias). Die Kontaktlöcher 122, 124 und 126 sind mit einer Liner/Barriereschicht 128 und mit Kupfer 130 gefüllt. Die Barriereschicht besteht beispielsweise aus Titannitrid. Unterhalb der Schmelzverbindung 116 enthält die Metalllage 108 Verbindungsabschnitte 132 und 134, welche zu Bauelementen führen, die über die Schmelzverbindung 116 verbunden sind.

Zwischen der Metalllage 108 und der Metalllage 102 liegt eine Barriereschicht 136 aus Siliziumnitrid mit einer Dicke kleiner 20 nm, beispielsweise mit einer Dicke von 15 nm. Alternativ wird auch ein BLOK-Material (Barrier low k) eingesetzt, z.B. Siliziumcarbid.

Die Metalllage 102 enthält im Bereich der Bondverbindung 110 eine Leitung 138, die zu der Bondverbindung führt. Im Bereich des Kondensators 112 enthält die Metalllage 102 eine untere Elektrode 140 des Kondensators 112. Im Bereich des Blockkondensators 114 enthält die Metalllage 102 eine untere Betriebsspannungsleitung 142. Im Bereich der Schmelzverbindung 116 enthält die Metalllage 102 zwei Verbindungsabschnitte 144 und 146, die zur Schmelzverbindung 116 führen.

Die Leitung 138, die untere Elektrode 140, die untere Betriebsspannungsleitung 142 und die Verbindungsabschnitte 144, 146 werden durch Kupfer 148 gebildet, das durch eine Liner/Barriereschicht 150 von dem Siliziumdioxid 152 getrennt ist, welches in der Metalllage 102 zur Isolation der einzelnen Verbindungen enthalten ist. Die Liner/Barriereschicht 150 besteht z.B. aus Titannitrid.

Zwischen der Metalllage 102 und der Metalllage 104 befindet sich eine Zwischenlage 160, deren Dicke D2 etwa 100 nm beträgt. Die Zwischenlage 160 besteht beispielsweise vollständig aus Siliziumnitrid.

Im Bereich der Bondverbindung 110 ist die Zwischenlage 160 von einem Kontaktloch 162 durchdrungen, das auch als Via bezeichnet wird, weil es zwischen zwei Metalllagen liegt. Im Bereich der Schmelzverbindung 116 wird die Zwischenlage 160 von zwei Kontaktlöchern bzw. Vias 164 und 166 durchdrungen. Die Kontaktlöcher bzw. Vias 162, 164 und 166 sind mit Aluminium 170 gefüllt. Eine Liner/Barriereschicht 172, beispielsweise aus Titannitrid, trennt das Aluminium 170 von der Zwischenlage 160 und dem Kupfer und verhindert so Diffusionsvorgänge. Die Liner/Barriereschicht 172 verhindert bzw. reduziert auch die Elektromigration. Die Zwischenlage 160 ist bis auf die Durchbrüche für die Kontaktlöcher 162 bis 166 und für weitere, nicht dargestellte Kontaktlöcher, ganzflächig im Bereich zwischen den Metalllagen 102 und 104 ausgebildet.

Die Metalllage 104 enthält im Bereich der Bondverbindung 110 eine Anschlussplatte 180 aus Aluminium 170. Im Bereich des Kondensators 112 enthält die Metalllage 104 eine obere Elektrode 182 des Kondensators 112 aus Aluminium 170. Im Bereich des Blockkondensators 114 enthält die Metalllage 104 eine obere Betriebsspannungsleitung 184 aus Aluminium 170. Im Bereich der Schmelzverbindung 116 enthält die Metalllage 104 einen Schmelzabschnitt 186 aus Aluminium 170. Der Schmelzabschnitt 186 überbrückt die Kontaktlöcher 164 und 166. Zur Isolation zwischen der Anschlussplatte 180, der oberen Elektrode 182, der oberen Betriebsspannungsleitung 184 bzw. des Schmelzabschnittes 186 enthält die Metalllage 104 Siliziumdioxid 190. Auf den oberen Flächen der Anschlussplatte 180, der oberen Elektrode 182, der oberen Betriebsspannungsleitung 184 bzw. des Schmelzabschnittes 186 befinden sich Reste einer Antireflexionsschicht 192. Das Siliziumdioxid 190 ist durch eine Passivierungsschicht 194 bedeckt, die beispielsweise aus Siliziumnitrid besteht.

Im Bereich der Bondverbindung 110 befindet sich eine Aussparung 196 in der Passivierungsschicht 194 und in dem Siliziumdioxid 190. Die Aussparung 196 endet auf der Anschlussplatte 180. In der Aussparung 196 befindet sich der Anschlusskopf 198 eines Bonddrahtes 200.

Eine weitere Aussparung 202 befindet sich im Bereich der Schmelzverbindung 116. Die Aussparung 202 durchdringt die Passivierungsschicht 194 und das Siliziumdioxid 190. Die Aussparung 202 endet in einem mittleren Bereich des Schmelzabschnittes 186. Durch die Aussparung 202 kann der Schmelzabschnitt 186 mit Hilfe eines Laserstrahls aufgeschmolzen und damit unterbrochen werden.

Zur Herstellung der Schaltungsanordnung 100 werden die folgenden Verfahrensschritte ausgeführt:
Herstellung der unteren Metalllagen 106, 108 und 102 aus Kupfer:
   - Die unteren Metalllagen 106, 108 und 102 werden durch Kupferabscheidung oder durch Abscheidung einer Kupferlegierung in einem Material mit einer kleinen Dielektrizitätskonstante k hergestellt, wobei beispielsweise die Damascene-Technik verwendet wird. Außerdem werden unterhalb der Bondverbindung 110 zur mechanischen Stabilisierung eine Vielzahl von Kontaktlöchern 122 bis 126 angeordnet.
   - Das Siliziumdioxid 152 bzw. ein anderes Material, z.B. FSG (Fluoride Silicate Glass), wird aufgebracht und mit Hilfe eines Lithografieverfahrens strukturiert. Anschließend werden die Liner/Barriereschicht 150 und das Kupfer 148 abgeschieden.
   - Die Liner/Barriereschicht 150 und das Kupfer 148 werden dann etwa bis auf die Höhe des Siliziumdioxids 152 mit Hilfe eines chemisch-mechanischen Polierverfahrens (CMP - Chemical Mechanical Polishing) abgetragen. Anschließend wird die Oberfläche gesäubert, beispielsweise mit Hilfe einer bürstenunterstützten Reinigung (Brush Clean).

Varianten zur Herstellung der Zwischenlage 160:
a) Es werden ca. 100 nm Siliziumnitrid als dielektrische Diffusionsbarriere und als Intermetall-Dielektrikum zur obersten Metalllage 104 abgeschieden, beispielsweise mit Hilfe eines CVD-Verfahrens (Chemical Vapor Deposition) oder mit Hilfe eines PECVD-Verfahrens (Plasma Enhanced CVD).
b) Es wird zunächst eine Schicht kleiner 20 nm Siliziumnitrid mit einem HDP-Verfahren (High Density Plasma) abgeschieden. Aufgrund des zusätzlichen Ionenbeschusses bei diesem Verfahren wird diese Siliziumnitridschicht verfestigt und bietet somit eine optimale Zuverlässigkeit gegen Elektromigration des Kupfers 148. Anschließend werden etwa 80 nm Siliziumnitrid mit Hilfe eines PECVD-Verfahrens abgeschieden, wobei die Abscheidung vorzugsweise mehrmals unterbrochen wird, um einen Mehrschichtstapel zu erzeugen, der eine optimale dielektrische Durchbruchsfestigkeit bietet.
c) Zunächst wird auf der gesäuberten Metalllage 102 eine Siliziumnitridschicht mit einer Dicke kleiner 20 nm unter Verwendung eines HDP-Verfahrens abgeschieden. Diese Schicht bietet optimale Zuverlässigkeit gegen Elektromigration. Danach werden etwa 80 nm eines Dielektrikums mit einer hohen Dielektrizitätskonstante k abgeschieden, um eine maximale flächenbezogene Kapazität zu erzielen. Geeignete Materialien sind unter anderem Al₂O₃ oder Ta₂O₅.
d) Es werden ca. 80 nm Aluminiumoxid (Al₂O₃)als Intermetall-Dielektrikum zur obersten Metalllage 104 abgeschieden.
e) Es wird ein Schichtstapel aus ca. 15 nm Al₂O₃, ca. 30 nm Ta₂O₅ und ca. 15 nm Al₂O₃ abgeschieden.

Kontaktlochherstellung (Via):
- Auf die Zwischenlage 160 wird ein Fotolack aufgebracht, gemäß der Strukturen für die Kontaktlöcher 162, 164 und 166 belichtet und entwickelt.
- Die Kontaktlöcher 162, 164 und 166 werden in die Zwischenlage 160 geätzt.
- Die Reste der Fotolackschicht werden entfernt.
- Die Kontaktlöcher 162, 164 und 166 werden gesäubert, beispielsweise in einem Nassreinigungsschritt, um möglicherweise am Boden der Kontaktlöcher 162, 164 und 166 abgesetztes Kupferoxid zu entfernen.

Herstellung der Metalllage 104:
- Die Barriereschicht 172 wird abgeschieden, wobei eine Sputter-Vorreinigung oder eine reaktive Vorreinigung, z.B. auf H2-Basis, ausgeführt wird. Geeignete Materialien für die metallische Diffusionsbarriere sind Ta, TaN, Ti, TiN, W, WN, usw. Geeignete Abscheideverfahren sind das PVD-Verfahren (Physical Vapor Deposition) oder das CVD-Verfahren.
- Das Aluminium 170 oder eine Aluminiumlegierung werden mit Hilfe eines PVD-Verfahrens oder mit Hilfe eines CVD-Verfahrens abgeschieden.
- Die Antireflexionsschicht 192 wird abgeschieden, beispielsweise eine Titannitridschicht, die mit Hilfe eines PVD-Verfahrens abgeschieden wird.
- Es wird ein Lithografieverfahren zur Strukturierung des Aluminiums 170 durchgeführt, wobei die Lage der Anschlussplatte 180, der oberen Elektrode 182, der oberen Anschlussleitung 184 und damit der oberen Platte des Blockkondensators 114, sowie des Schmelzabschnittes 186 festgelegt werden. Zusätzlich kann die Lage von Spulen oder von Verbindungen zum Führen von Signalen festgelegt werden.
- Das Aluminium 170 wird geätzt, wobei an der oberen Fläche der Zwischenlage 160 gestoppt wird.
- Der Fotolack wird entfernt und es wird ein Säuberungsschritt durchgeführt.

Abschließende Passivierung:
- Es wird das Siliziumdioxid 190 bzw. ein anderes geeignetes Material, z.B. FSG, abgeschieden. Anschließend wird die Nitridschicht 194 abgeschieden.
- Es wird ein Lithografieverfahren zum Festlegen der Lage der Aussparungen 196 und 202 ausgeführt, d.h. der zur Anschlussplatte 180 bzw. zum Schmelzabschnitt 186 führenden Öffnungen.
- Die Aussparungen 196 und 202 werden geätzt.
- Der Fotolack wird entfernt und es wird ein Säuberungsschritt ausgeführt.

Optional kann die Öffnung der Aussparungen 196 und 202 auch mit einem fotosensitiven Polyimid als Maske erfolgen. Das an Hand der Figur 2 erläuterte Verfahren lässt sich auch dann ausführen, wenn in der Metalllage 102 oder auch in allen unteren Metalllagen an Stelle des Kupfers eine Kupferlegierung verwendet wird. Dabei bleiben insbesondere die Varianten zur Herstellung der Zwischenlage 160 und die Verfahrensschritte zum Herstellen der darüber liegenden Struktur unverändert.

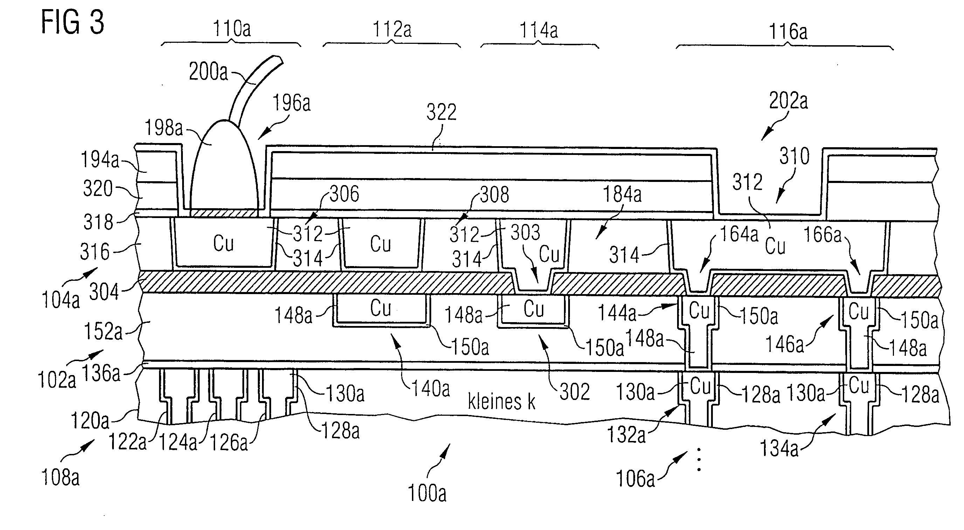

An Stelle des Aluminiums in der Metalllage 104 lässt sich auch Kupfer oder eine Kupferlegierung verwenden. Will man die sich beim Ätzen des Kupfers ergebenden Nachteile vermeiden, so wird das Kupfer mit einer Dualen-Damascene-Technik strukturiert, siehe Figur 3.

Figur 3 zeigt eine Schaltungsanordnung 100a mit einer vorletzten Metalllage 102a und einer letzten Metalllage 104a, die beide Kupfer oder eine Kupferlegierung enthalten. Bei der Schaltungsanordnung 100a wurden in der obersten Metalllage 104a zuerst Kontaktlöcher 164a und 166a und dann Gräben für Verbindungsabschnitte der Metalllage 104a hergestellt. In Figur 3 werden Elemente mit der gleichen Struktur und Funktion wie Elemente, die an Hand der Figur 2 erläutert worden sind, durch gleiche Bezugszeichen bezeichnet, wobei dem Bezugszeichen jedoch zur Unterscheidung der Kleinbuchstabe a nachgestellt ist. Diese Elemente werden nicht noch einmal erläutert, weil die oben stehenden Erläuterungen gelten.

Zwischen den Figuren 2 und 3 ergeben sich die folgenden Abweichungen. Es ist in Figur 3 ein anderer Schnitt durch die Schaltungsanordnung dargestellt als in Figur 2. Deshalb fehlt beispielsweise die erfindungsgemäße Leitung unter der Bondverbindung 110a sowie das zur Bondverbindung 110a gehörende erfindungsgemäße Kontaktloch bzw. Via. An Stelle des Blockkondensators 114 wird in Figur 3 eine Kontaktierung 300 gezeigt, mit deren Hilfe eine der Leitung 184 entsprechende Leitung 184a mit einer Betriebsspannungsleitung 302 in der Metalllage 102a verbunden ist. Die Kontaktierung 300 liegt in einem Kontaktloch bzw. Via 303.

Zwischen den Metalllagen 104a und 102a liegt eine Zwischenlage 304, die beispielsweise vollständig aus Siliziumnitrid besteht. Varianten zur Erzeugung der Zwischenlage 304 werden weiter unten erläutert.

In der Metalllage 104a befindet sich im Bereich der Bondverbindung 110a eine Anschlussplatte 306, im Bereich des linearen Kondensators 112a eine obere Elektrode 308, im Bereich der Kontaktierung 300 die Betriebsspannungsleitung 184a und im Bereich der Schmelzverbindung 116a ein Schmelzabschnitt 310. Die Anschlussplatte 306, die obere Elektrode 308, die Betriebsspannungsleitung 184a und der Schmelzabschnitt 310 bestehen aus Kupfer 312, das durch eine Barriereschicht 314, z.B. aus Titannitrid, von einem in der Metalllage 104a enthaltenen Siliziumdioxid 316 getrennt ist. Anstelle des Kupfers 312 kann auch eine Kupferlegierung verwendet werden.

Auf der Metalllage 104a befindet sich eine Barriereschicht 318, die beispielsweise aus Siliziumnitrid besteht. Auf der Barriereschicht 318 befindet sich eine Oxidschicht 320, beispielsweise Siliziumdioxid, das Teil einer Passivierung ist. Die Passivierung wird auch durch die auf der Oxidschicht 320 liegende Passivierungsschicht 194a erbracht, beispielsweise einer Siliziumnitridschicht.

Auf der Passivierungsschicht 194a sowie in den Aussparungen 196a und 202a befindet sich eine dünne dielektrische Schicht 322, die beispielsweise kleiner als 5 nm dick ist. Die dielektrische Schicht 322 besteht beispielsweise aus Siliziumnitrid.

Beim Herstellen der Schaltungsanordnung 100a werden die folgenden Verfahrensschritte ausgeführt:
Herstellen der unteren Metalllagen 106a, 108a und 102a:
   - Es wird auf die Ausführungen zur Figur 2 verwiesen.
Varianten zur Herstellung der Zwischenlage 304:
   d, e) vgl. Variante d bzw. e zur Herstellung der Zwischenlage 160.
   f) Es wird eine Siliziumnitridschicht mit einer Dicke größer als 50 nm als dielektrische Diffusionsbarriere und Intermetall-Dielektrikum abgeschieden. Die Dicke des Dielektrikums ist durch die Ätzselektivität zwischen Oxidschicht/FSG und Siliziumnitrid begrenzt. Nach der Ätzung des Grabens für die obere Elektrode 308 muss im Bereich des Kondensators 112a noch ein elektrisch zuverlässiges Dielektrikum übrig bleiben.
   g) Es wird zunächst eine Siliziumnitridschicht mit einer Dicke kleiner 20 nm abgeschieden. Dabei wird ein HDP-Verfahren eingesetzt, um eine optimale Zuverlässigkeit gegenüber Elektromigration zu erreichen. Anschließend wird eine Siliziumnitridschicht größer 30 nm mit einem PECVD-Verfahren abgeschieden, vorzugsweise als Mehrfachschichtstapel für eine optimale dielektrische Durchbruchsfestigkeit.
   h) Zunächst wird eine Siliziumnitridschicht mit einer Dicke kleiner 20 nm unter Verwendung eines HDP-Verfahrens abgeschieden. Anschließend wird eine Schicht mit einer Dicke größer 30 nm abgeschieden, die aus einem Dielektrikum mit einer hohen Dielektrizitätskonstante k besteht, z.B. Al₂O₃ oder Ta₂O₅. Diese Schicht führt zu einer maximalen flächenbezogenen Kapazität des linearen Kondensators 112a bzw. von Blockkondensatoren in der Schaltungsanordnung 100a. Auch in diesem Fall sollte die Gesamtdicke der Zwischenlage 304 größer als 50 nm sein. Die Dicke der Zwischenlage 304 ist durch die Ätzselektivität zwischen Oxidschicht/FSG und der Schicht mit der hohen Dielektrizitätskonstante k nach unten hin begrenzt.
Herstellung der Metalllage 104a, Kontaktlochherstellung:
   - Das Siliziumdioxid 316 oder ein anderes geeignetes Material, z.B. FSG, wird abgeschieden.
   - Ein Lithografieverfahren wird zum Festlegen der Lage der Kontaktöffnungen 303, 164a, 166a ausgeführt.
   - Es werden Kontaktlöcher im Siliziumdioxid 316 oberhalb der späteren Lage der Kontaktlöcher 303, 164a und 166a geätzt. Der Ätzvorgang stoppt auf der Zwischenlage 304.
   - Der Fotolack wird entfernt.
   - Die Kontaktlöcher werden durch die Zwischenlage 304 hindurchgeätzt, bis das Kupfer 148a freigelegt ist.
Herstellung von Gräben in der Metalllage 104a:
   - Es wird ein Lithografieverfahren ausgeführt, um die Lage der Gräben festzulegen, in denen das Kupfer 312 eingebracht werden soll.
   - Die Gräben werden geätzt, wobei auf der Zwischenlage 304 gestoppt wird. Dabei werden die Gräben für die Anschlussplatte 306, für die obere Elektrode 308, für die Betriebsspannungsleitung 184 und für den Anschlussabschnitt 310 hergestellt. Zusätzlich lassen sich gleichzeitig Gräben für Betriebsspannungsleitungen mit Block-Kapazitäten, für Signalleitungen oder für Spulen erzeugen.
   - Der Fotolack wird entfernt.
   - Die Kontaktlöcher werden gereinigt, beispielsweise mit einem Nassreinigungsschritt (z.B. EKC 525), um möglicherweise am Boden der Kontaktlöcher entstandenes Kupferoxid zu entfernen.
Weitere Herstellung der Metalllage 104a:
   - Die Barriereschicht 314 wird abgeschieden, wobei eine Sputter-Vorreinigung oder eine reaktive Vorreinigung (z.B. auf der Basis von H₂) ausgeführt werden sollte. Die Barriereabscheidung wird beispielsweise mit Hilfe eines PVD-Verfahrens oder mit Hilfe eines CVD-Verfahrens durchgeführt. Es lassen sich die gleichen Materialien verwenden, wie für die Barriereschicht 172.
   - Es wird anschließend eine Kupferschicht mit Wachstumskeimen abgeschieden, z.B. mittels PVD-Verfahren oder mittels CVD-Verfahren, oder mittels eines stromlosen Verfahrens aus einer Lösung.
   - Das Kupfer 312 wird mit Hilfe eines Dualen-Damascene-Füllverfahrens eingebracht, beispielsweise mit Hilfe eines ECD-Verfahrens (Electrochemical Deposition).
   - Das Kupfer 312 und die Barriereschicht 314 werden mit Hilfe eines CMP-Verfahrens außerhalb der Gräben abgetragen.
   - Die Barriereschicht 318 wird aufgebracht. Die Barriereschicht 318 hat eine Dicke von etwa 20 nm bis etwa 30 nm. Beispielsweise wird Siliziumnitrid mit Hilfe eines PECVD-Verfahrens oder mit Hilfe eines HDP-Verfahrens aufgebracht. Es lassen sich jedoch auch andere Materialien verwenden, z.B. ein Barrierenmaterial mit einer kleinen Dielektrizitätskonstante k (BloK - Barrier low k).
Herstellung der Passivierung:
   - Anschließend wird die Passivierung hergestellt, beispielsweise durch Aufbringen der Siliziumdioxidschicht 320 und der Siliziumnitridschicht 194a.
   - Es wird ein Lithografieverfahren zum Festlegen der Lage der Aussparungen 196a und 202a durchgeführt.
   - Die Aussparungen 196a und 202a werden geätzt, wobei auf der Barrierenschicht 318 gestoppt wird.
   - Der Fotolack wird entfernt.
   - Die Barriereschicht 318 wird im Bereich der Aussparungen 196a und 202a durchgeätzt.
   - Es wird die extrem dünne aber dichte dielektrische Schicht 322 abgeschieden, die beispielsweise eine Dicke kleiner 5 nm hat. Zum Abscheiden wird beispielsweise ein ALCVD-Verfahren (Atomic Layer CVD) verwendet. Als Material ist Siliziumnitrid geeignet. Durch die dielektrische Schicht 322 wird die Kupferanschlussplatte 306 und der Schmelzabschnitt 310 vor Korrosion und Oxidation geschützt. Die dielektrische Schicht 322 muss jedoch so dünn sein, dass trotzdem auf der Cu-Anschlussplatte 306 gebondet werden kann.

Zusätzlich zu den bereits genannten Vorteilen der Erfindung, der Weiterbildungen bzw. der Ausführungsbeispiele soll noch auf die folgenden Aspekte hingewiesen werden:
- die oberste Aluminiumebene lässt sich für vergleichsweise dicke und breite Betriebsspannungsleitungen nutzen. Die Herstellung einer Verdrahtungsebene aus Aluminium ohne Wolfram-Füllungen in den Kontaktlöchern (Vias) ist kostengünstiger als eine Kupferebene mit einem CMP-Verfahren herzustellen. Weil es nicht notwendig ist, die letzte Metallebene zu planarisieren, ist eine Kupferebene nicht erforderlich.
- Für die Strukturierung der letzten Aluminiumebene können bereits vorhandene Anlagen verwendet werden, weil die Anforderungen an die Lithografie vergleichsweise entspannt sind.
- Es ist möglich, auch in den letzten beiden Metalllagen Signale zu führen, z.B. niederohmige Zuführleitungen (Line out's) oder besonders empfindliche Mischsignal-Signalleitungen. Werden Signalleitungen in den beiden kapazitiv stark gekoppelten Metalllagen angeordnet, so ist darauf zu achten, dass sich Signallagen nicht überkreuzen. Alternativ ist es jedoch auch möglich, die Signalleitungen in beiden Ebenen parallel zu verdrahten und somit besonders niederohmige Signalleitungen zu ermöglichen. Der Zusatzaufwand dafür ist gering, weil lediglich eine zusätzliche Layout-Ebene vorzusehen ist, was sich software-technisch lösen lässt.
- Stärkere kapazitive Kopplungen zwischen Signalleitungen in einer der beiden Ebenen können vermieden werden, indem man die minimalen Abstände zwischen Signalleitungen in der letzten Metalllage bzw. in der vorletzten Metalllage etwas verbreitert, z.B. um 10 bis 20 %.

## Patentansprüche

1. Integrierte Schaltungsanordnung (10, 100),
mit in einem Halbleiter-Substrat (12) angeordneten Bauelementen,
mit zwei obersten Verbindungslagen, die jeweils mindestens einen elektrisch leitenden Verbindungsabschnitt (148, 170) enthalten, der Teil einer elektrisch leitenden Verbindung zu einem Bauelement ist,
wobei die obere der beiden Verbindungslagen als Hauptbestandteil Kupfer oder Aluminium oder eine Kupfer- oder Aluminiumlegierung enthält und die untere der beiden Verbindungslagen aus Kupfer oder einer Kupferlegierung besteht,
und mit einer zwischen den Verbindungslagen angeordneten Zwischenlage (160) aus mindestens einem dielektrischen Material,
wobei die Zwischenlage (160) die flächenbezogene Kapazität zwischen den Verbindungslagen festlegt,
wobei die Zwischenlage (160) so ausgebildet ist, dass die flächenbezogene Kapazität zwischen den Verbindungslagen größer als 0,5 fF/µm² ist,
wobei die Zwischenlage (160) mindestens ein Material mit einer Dielektrizitätskonstante größer 4 enthält,
und wobei der Abstand zwischen den Verbindungslagen kleiner als 200 nm ist,
und mit einem Kontaktloch (162), das nur die Zwischenlage (160) durchdringt und in der oberen der beiden Verbindungslagen eine Anschlussplatte (180) eines Anschlusses zum Anschließen einer äußeren elektrisch leitenden Bondverbindung (200) mit einem unter ihr liegenden Verbindungsabschnitt (138) in der unteren der beiden Verbindungslagen verbindet, wobei das Metall der Anschlussplatte (180) das Kontaktloch (162) füllt,
mit mindestens einem Verbindungsabschnitt (184) in der einen Verbindungslage und mit mindestens einem Verbindungsabschnitt (142) in der anderen Verbindungslage zum Führen einer Betriebsspannung, wobei sich diese Verbindungsabschnitte (184, 142) senkrecht zu einer Verbindungslage gesehen in einem Gebiet überlappen, das einen Kondensator (C2, C3) bildet, der im Betrieb der Schaltungsanordnung (10, 100) auftretende Störimpulse unterdrückt,
und wobei die Schaltungsanordnung (10, 100) eine Passivierungsschicht (194) zum Schutz vor Umwelteinflüssen enthält,
wobei die Passivierungsschicht (194) mindestens eine Aussparung (196) enthält, die zu der Anschlussplatte (180) führt.

2. Schaltungsanordnung (10, 100) nach Anspruch 1, **dadurch gekennzeichnet dass** die Passivierungsschicht (194) mindestens eine weitere Aussparung (202) enthält, die zu einem weiteren Verbindungsabschnitt (186) der obersten Verbindungslage führt,
und dass der weitere Verbindungsabschnitt (186) eine Schmelzverbindung ist, mit deren Hilfe eine von mindestens zwei Schaltungsvarianten ausgewählbar ist oder ausgewählt worden ist.

3. Schaltungsanordnung (10, 100) nach einem der vorhergehenden Ansprüche, **dadurch gekennzeichnet, dass** dass die zum Führen der Betriebsspannung vorgesehenen Verbindungsabschnitte (184, 142) in einem mit digitalen Signalen arbeitenden Schaltungsteil (16) der Schaltungsanordnung (10, 100) angeordnet sind.

4. Schaltungsanordnung (10, 100) nach einem der vorhergehenden Ansprüche, **dadurch gekennzeichnet, dass** die Verbindungslagen die Elektroden (140, 182) mindestens eines weiteren Kondensators (C1, 72) enthalten,
und dass ein Teil der Zwischenlage (160, 400) im Bereich des weiteren Kondensators (C1, 72) das Dielektrikum bildet,
wobei der weitere Kondensator (C1, 72) vorzugsweise in einem mit analogen Signalen arbeitenden Schaltungsteil (14) der Schaltungsanordnung (10, 100) angeordnet ist.

5. Schaltungsanordnung (10, 100) nach einem der vorhergehenden Ansprüche, **dadurch gekennzeichnet, dass** die flächenbezogene Kapazität zwischen den Verbindungslagen größer als 0,7 fF/µm² oder etwa 2,0 fF/µm² ist,
und/oder dass die Verbindungslagen voneinander einen Abstand kleiner 150 nm haben, vorzugsweise einen Abstand von etwa 100 nm.

6. Schaltungsanordnung (10, 100) nach einem der vorhergehenden Ansprüche, **dadurch gekennzeichnet, dass** die Zwischenlage (160) mindestens einen der Bestandteile Nitrid, vorzugsweise Siliziumnitrid oder Aluminiumnitrid, Tantaloxid, Hafniumoxid oder Aluminiumoxid enthält.

7. Schaltungsanordnung (10, 100) nach einem der vorhergehenden Ansprüche, **dadurch gekennzeichnet, dass** zwischen der unteren der beiden Verbindungslagen und der Zwischenlage (160) eine Hilfslage angeordnet ist, die an den Verbindungsabschnitten (148) der unteren Verbindungslage Gebiete enthält, die hauptsächlich eine Kupferverbindung aus Kupfer und mindestens einem der Materialien Kobalt, Wolfram, Phosphor oder Bor enthält.

## Claims

1. Integrated circuit arrangement (10, 100),
having components arranged in a semiconductor substrate (12),
having two topmost connection layers, which each contain at least one electrically conductive connection section (148, 170) which is part of an electrically conductive connection to a component,
the upper one of the two connection layers containing copper or aluminium or a copper or aluminium alloy as main constituent and the lower one of the two connection layers consisting of copper or a copper alloy,
and having an intermediate layer (160) made of at least one dielectric material, which intermediate layer is arranged between the connection layers,
the intermediate layer (160) defining the capacitance per unit area between the connection layers,
the intermediate layer (160) being designed in such a way that the capacitance per unit area between the connection layers is greater than 0.5 fF/µm²,
the intermediate layer (160) containing a material having a dielectric constant of greater than 4,
and the distance between the connection layers being less than 200 nm,
and having a contact hole (162) which only penetrates through the intermediate layer (160), and
connects a terminal plate (180) - in the upper of the two connection layers - of a terminal for connecting an external electrically conductive bonding connection (200) to a connection section (138) situated thereunder in the lower of the two connection layers,
the metal of the terminal plate (180) filling the contact hole (162),
having at least one connection section (184) in one connection layer and having at least one connection section (142) in the other connection layer for carrying an operating voltage, the connection sections (184, 142) overlapping, as seen perpendicularly to a connection layer, in a region which forms a capacitor (C2, C3), which suppresses interference pulses occurring during operation of the circuit arrangement (10, 100),
and the circuit arrangement (10, 100) containing a passivation layer (194) for protection against ambient influences,
the passivation layer (194) containing at least one cut-out (196), which leads to the terminal plate (180).

2. Circuit arrangement (10, 100) according to Claim 1, **characterized**
**in that** the passivation layer (194) contains at least one further cut-out (202), which leads to a further connection section (186) of the topmost connection layer,
and **in that** the further connection section (186) is a fuse connection with the aid of which one of at least two circuit variants can be selected or has been selected.

3. Circuit arrangement (10, 100) according to one of the preceding claims, **characterized in that** the connection sections (184, 142) provided for carrying the operating voltage are arranged in a circuit section (16) of the circuit arrangement (10, 100) that operates with digital signals.

4. Circuit arrangement (10, 100) according to one of the preceding claims, **characterized in that** the connection layers contain the electrodes (140, 182) of at least one further capacitor (C1, 72),
and **in that** a part of the intermediate layer (160, 400) in the region of the further capacitor (C1, 72) forms the dielectric,
the further capacitor (C1, 72) preferably being arranged in a circuit section (14) of the circuit arrangement (10, 100) that operates with analogue signals.

5. Circuit arrangement (10, 100) according to one of the preceding claims, **characterized in that** the capacitance per unit area between the connection layers is greater than 0.7 fF/µm² or approximately 2.0 fF/µm², and/or **in that** the connection layers have a distance of less than 150 nm, preferably a distance of about 100 nm, between one another.

6. Circuit arrangement (10, 100) according to one of the preceding claims, **characterized in that** the intermediate layer (160) contains at least one of the constituents nitride, preferably silicon nitride or aluminium nitride, tantalum oxide, hafnium oxide or aluminium oxide.

7. Circuit arrangement (10, 100) according to one of the preceding claims, **characterized in that** an auxiliary layer is arranged between the lower of the two connection layers and the intermediate layer (160), which auxiliary layer contains, at the connection sections (148) of the lower connection layer, regions which principally contain a copper compound comprising copper and at least one of the materials cobalt, tungsten, phosphorus or boron.

## Revendications

1. Circuit (10, 100) intégré,
comprenant des composants disposés dans un substrat (12) semi-conducteur,
comprenant deux couches de liaison les plus hautes qui contiennent respectivement au moins un segment (148, 170) de liaison, conducteur de l'électricité, qui fait partie d'une liaison conductrice de l'électricité menant à un composant,
dans lequel la couche supérieure des deux couches de liaison contient comme partie constitutive principale du cuivre ou de l'aluminium ou un alliage de cuivre ou d'aluminium et la couche inférieure des deux couches de liaison est en cuivre ou en un alliage de cuivre,
et comprenant une couche (160) intermédiaire en au moins un matériau disposée entre les deux couches de liaison,
dans lequel la couche (160) intermédiaire fixe la capacité rapportée à la surface entre les couches de liaison,
dans lequel la couche (160) intermédiaire est conformée de manière à ce que la capacité rapportée à la surface entre les couches de liaison soit plus grande que 0,5 fF /µm², dans lequel la couche (160) intermédiaire contient au moins un matériau ayant une constante diélectrique plus grande que 4 et,
dans lequel la distance entre les couches de liaison est plus petite que 200 nm,
et comprenant un trou (162) de contact, qui ne traverse que la couche (160) intermédiaire et, dans la couche supérieure des deux couches de liaison, une plaque (180) d'une borne relie, pour le raccordement d'une liaison (200) de bonding extérieure conductrice de l'électricité à une surface (138) de liaison dans la couche inférieure des deux couches de liaison,
dans lequel le métal de la plaque (180) de borne remplit le trou (162) de contact,
comprenant au moins une section (184) de liaison dans l'une des couches de liaison et au moins une section (142) de liaison dans l'autre couche de liaison pour l'application d'une tension de fonctionnement, dans lequel les surfaces (184, 142) de liaison se chevauchent considéré perpendiculairement à la couche de liaison, dans une zone qui forme un condensateur (C2, C3) qui supprime des impulsions parasites se produisant lorsque le circuit (10, 100) fonctionne et dans lequel le circuit comporte une couche (194) de passivation pour se protéger des influences ambiantes,
dans lequel la couche (194) de passivation comporte au moins un évidement (196) qui mène à la plaque (180) de borne.

2. Circuit (10, 100) suivant la revendication 1, **caractérisé en ce que** la couche (194) de passivation comporte au moins un autre évidemment (202) qui mène à une autre section (186) de liaison de la couche la plus haute de liaison,
et **en ce que** l'autre section (186) de liaison est une liaison fusible, à l'aide de laquelle l'une parmi au moins deux variantes de circuit peut être choisie ou a été choisie.

3. Circuit (10, 100) suivant l'une des revendications précédentes, **caractérisé en ce que** les sections (184, 142) de liaison, prévues pour appliquer la tension de fonctionnement, sont disposées dans une partie (16) du circuit (10, 100) fonctionnant avec des signaux numériques.

4. Circuit (10, 100) suivant l'une des revendications précédentes, **caractérisé en ce que** les couches de liaison comportent les électrodes (140, 182) d'au moins un autre condensateur (C1, 72),
**en ce qu'**une partie de la couche (160, 400) intermédiaire forme le diélectrique dans la zone de l'autre condensateur (C1 , 72),
dans lequel l'autre condensateur (C1, 72) est disposé de préférence dans une partie (14) du circuit (10, 100) fonctionnant avec des signaux analogiques.

5. Circuit (10, 100) suivant l'une des revendications précédentes, **caractérisé en ce que** la capacité rapportée à la surface entre les couches de liaison est plus grande que 0,7fF /µm² ou est d'à peu près 2,0 fF /µm²,
et/ou les couches de liaison sont à une distance l'une de l'autre plus petites que 150 nm, de préférence à une distance d'environ 100 nm.

6. Circuit (10, 100) suivant l'une des revendications précédentes, **caractérisé en ce que** la couche (160) intermédiaire contient au moins l'un des constituants nitrure, de préférence nitrure de silicium ou nitrure d'aluminium, oxyde de tantale, oxyde d'hafnium ou oxyde d'aluminium.

7. Circuit (10, 100) suivant l'une des revendications précédentes, **caractérisé en ce qu'**entre la couche inférieure des deux couches de liaison et la couche (160) intermédiaire est disposée une couche auxiliaire qui comporte, aux sections (148) de liaison de la couche inférieure de liaison, des zones contenant principalement un composé de cuivre, en cuivre et en au moins l'un des matériaux cobalt, tungstène, phosphore ou bore.
